# EUROPEAN PATENT APPLICATION

(11) **EP 4 257 735 A1**
(43) Date of publication of application: **11.10.2023**
(21) Application number: 22742531.1
(22) Date of filing: 17.01.2022
(51) Int. Cl.: C30B 29/36, C23C 14/06, C30B 23/06

(54) **SIC SINGLE CRYSTAL GROWING APPARATUS**

(30) Priority: 21.01.2021 JP 2021007905
(71) Applicant: Sec Carbon, Ltd., Amagasaki-shi, Hyogo, 661-0976 (JP)
(72) Inventor: SHIOMI, Hiromu, Amagasaki-shi, Hyogo 661-0976 (JP)
(74) Representative: J A Kemp LLP
(86) International application number: PCT/JP2022/001309
(87) International publication number: WO 2022/158409

(57) **Abstract**

An SiC single-crystal growth apparatus is provided that is capable of uniformly heating solid source material to sublimate it into gaseous material and capable of reducing wasted material during the growth of an SiC single crystal. An SiC single-crystal growth apparatus (1) includes: a heating vessel (10) including a material containing portion (12) that contains solid source material (M(s)) of SiC in a portion of the interior space (S) defined by a cylindrical peripheral side portion (14), and a seed-crystal mounting portion (16) located in a portion of the interior space (S) of the material containing portion (12) that does not contain the solid source material (M(s)), the seed-crystal mounting portion adapted to allow a seed crystal (2) of SiC to be placed thereon; and a heating member (3) that heats the heating vessel (10), the heating member (3) including a first heating sub-member (31) having a first heating surface (31a) positioned outside of the heating vessel (10) to face a major surface portion of the material containing portion (12) in such a positional relationship as to cover the entire outer surface of the major surface portion, the major surface portion located opposite to the seed-crystal mounting portion (16), the apparatus satisfying the relationship B/A≥2, where A is the sectional area of the interior space S, and B is the area of the first heating surface (31a).

## Description

### TECHNICAL FIELD

The present invention relates an SiC single-crystal growth apparatus.

### BACKGROUND ART

Silicon carbide (SiC) provides excellent electric properties, namely, a dielectric breakdown field that is approximately one order of magnitude higher, and a bandgap that is approximately three times larger, than those of silicon (Si). Further, SiC provides an excellent thermal property, namely, a thermal conductivity that is approximately three times as high as that of Si. Due to these excellent properties, SiC is expected to be used in various devices, such as power devices, high-frequency devices, and high-temperature operating devices.

These devices are fabricated by machining an SiC single-crystal ingot to produce an SiC single-crystal substrate and using chemical vapor deposition (CVD) and/or other methods to form an epitaxial layer that is to provide an active region of the resulting device. One known method of forming an SiC single-crystal ingot is the sublimation method.

The sublimation method involves: positioning a seed crystal, composed of an SiC single crystal, inside a crucible made of graphite; heating the crucible to cause the material powder (i.e., raw material) in the crucible to sublimate into sublimated gas; supplying this gas to the seed crystal to grow the seed crystal into a larger SiC single-crystal ingot.

A crucible used to form an SiC single crystal with the sublimation method is described in Patent Document 1, which discloses a crucible including a plurality of seed crystal-positioning portions. More specifically, it discloses a crucible including seed crystal-positioning portions on which seed crystals are to be positioned and a source material containing portion capable of containing source material, where sublimated material gas can pass through an opening of the source material containing portion to reach the seed crystals, the source material containing portion having an interior surface area not larger than three times the area of the opening of the source material containing portion. Further, Patent Document 1 discloses a method of growing a crystal including the step of preparing a crystal growth apparatus including such a crucible, positioning seed crystals on the seed crystal-positioning portions such that the distance between the seed crystals and the source material is not larger than 0.21 times the distance between adjacent ones of the seed crystal-positioning members (or their centers), and placing the material inside the material containingportion.

Another method of manufacturing an SiC single-crystal ingot with the sublimation method is described in Patent Document 2, which discloses a method for improving the uniformity of source material temperature. More specifically, Patent Document 2 discloses forming a material body by positioning, in a lower portion of the crucible, a high-thermal-conductivity material layer having a source material with high thermal conductivity and a low-thermal-conductivity material layer having a source material with low thermal conductivity on at least one of the upper surface and the lower surface of that high-thermal-conductivity material layer, and heating the material body in such a manner that the location of the maximum temperature within the material body is inside the high-thermal-conductivity material layer.

### PRIOR ART DOCUMENTS

### PATENT DOCUMENTS

Patent Document 1: JP 2000-219594
Patent Document 2: JP 2020-083704

### SUMMARY OF THE INVENTION

### PROBLEMS TO BE SOLVED BY THE INVENTION

The crucible and the method of growing a crystal of Patent Document 1 stabilize vapor pressure by ensuring that the interior surface area of the source material containing portion is not larger than three times the area of the opening of the source material containing portion; however, the document only presents examples where seven small SiC single crystals with a diameter of 2 inches are formed simultaneously, and does not discuss cases where large SiC single crystals with diameters not smaller than 6 inches, for example, are to be grown, nor cases where more SiC single crystals are to be grown. Particularly, if large SiC single crystals are to be grown or more SiC single crystals are to be grown, the volume of the interior space of the crucible (particularly, the sectional area of the interior space) is too large to allow solid-source-material-derived gaseous material, produced by sublimating a solid source material in the crucible, to uniformly reach the plurality of seed crystals positioned in an upper portion of the crucible. Thus, the crucible and the method of growing a crystal of Patent Document 1 lead to SiC single crystals growing non-uniformly, which results in larger amounts of wasted material; in addition, the larger crucible means a larger weight of the crucible, which is difficult to handle.

The method of Patent Document 2 controls the grain sizes of the source materials constituting the high-thermal-conductivity material layer and the low-thermal-conductivity material layer, as well as the void fractions of these layers, to control the thermal conductivity of the material body, and heating the material body in such a manner that the location of the maximum temperature within the material body is inside the high-thermal-conductivity material layer of the material body, thereby sublimating the material body uniformly. However, the sublimation of the material body changes the composition of the material body, which in turn changes the thermal conductivity of the material body; as such, it is difficult to uniformly sublimate the solid source material throughout the process of crystal growth.

An object of the present invention is to provide an SiC single-crystal growth apparatus capable of uniformly heating solid source material contained in a heating vessel (e.g., a plurality of crucibles) to sublimate it into solid-material-derived gaseous material and, at the same time, capable of reducing wasted material during the growth of an SiC single crystal.

### MEANS FOR SOLVING THE PROBLEMS

The present inventors discovered that source material can be uniformly sublimated throughout the process of crystal growth if the relationship B/A≥2 is satisfied, where A is the sectional area of the interior space of a material containing portion, and B is the area of the a first heating surface of a first heating sub-member, the first heating surface positioned to face a major surface portion of the material containing portion in such a positional relationship as to cover the entire outer surface of the major surface portion, and arrived at the present invention.

Specifically, the construction of the present invention is outlined as follows:
(1) An SiC single-crystal growth apparatus including: a heating vessel including a material containing portion having a cylindrical peripheral side portion and adapted to contain solid source material of SiC in a portion of an interior space defined by the peripheral side portion, and a seed-crystal mounting portion located in a portion of the interior space of the material containing portion that does not contain the solid source material, the seed-crystal mounting portion adapted to allow a seed crystal of SiC to be placed thereon; and a heating member adapted to heat the heating vessel, the heating member including at least a first heating sub-member having a first heating surface positioned outside of the heating vessel to face a major surface portion of the material containing portion in such a positional relationship as to cover an entire outer surface of the major surface portion, the major surface portion located opposite to the seed-crystal mounting member, the apparatus satisfying the relationship B/A≥2, where A is a sectional area of the interior space and B is an area of the first heating surface.
(2) The SiC single-crystal growth apparatus according to apparatus (1) above, where: the heating member further includes a second heating sub-member having a second heating surface positioned outside of the heating vessel to face the peripheral side portion of the material containing portion in such a positional relationship as to cover an entire outer surface of the peripheral side portion; and C is larger than D, where C is heating energy of the first heating sub-member and D is heating energy of the second heating sub-member.
(3) The SiC single-crystal growth apparatus according to apparatus (2) above, where the heating energy C of the first heating sub-member and the heating energy D of the second heating sub-member satisfy the relationship C/D≥1.20.
(4) The SiC single-crystal growth apparatus according to apparatus (1), (2) or (3) above, wherein the heating vessel includes a plurality of crucibles, and the SiC single-crystal growth apparatus further includes a chamber adapted to contain the plurality of crucibles and the heating member, wherein the plurality of crucibles each include a clearance for releasing, from the associated material containing portion to inside the chamber, a portion of solid-material-derived gaseous material produced by sublimating the solid source material contained in the material containing portion.
(5) The SiC single-crystal growth apparatus according to any one of apparatus (1) to (4) above, where the first heating surface of the heating member is formed from an anisotropic material anisotropic in at least thermal conductivity.
(6) The SiC single-crystal growth apparatus according to apparatus (5) above, where the anisotropic material is a carbon material containing carbon fiber.
(7) The SiC single-crystal growth apparatus according to any one of apparatus (1) to (6) above, where: the heating member includes a heat source for the first heating surface, the heating source located on a side of the first heating sub-member opposite to the first heating surface; and the heating source is formed by a resistance heating device including a power-feed mechanism with three-phase alternating current.

### EFFECTS OF THE INVENTION

The present invention provides an SiC single-crystal growth apparatus capable of uniformly heating solid source material contained in a heating vessel to sublimate it into the solid-material-derived gaseous material and, at the same time, capable of reducing wasted material during the growth of an SiC single crystal.

### BRIEF DESCRIPTION OF THE DRAWINGS

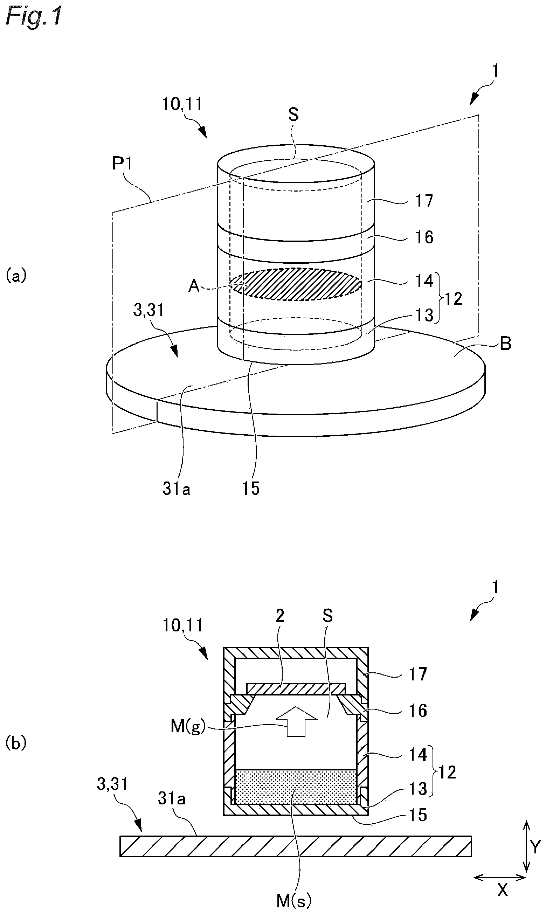

[FIG. 1] FIG. 1 shows an SiC single-crystal growth apparatus of a first embodiment the present invention, schematically illustrating the structure of its main components, FIG. 1(a) being a perspective view showing a crucible as being transparent so its interior space S is visible, FIG. 1(b) being a cross-sectional view of the apparatus taken on imaginary plane P1 of FIG. 1(a).

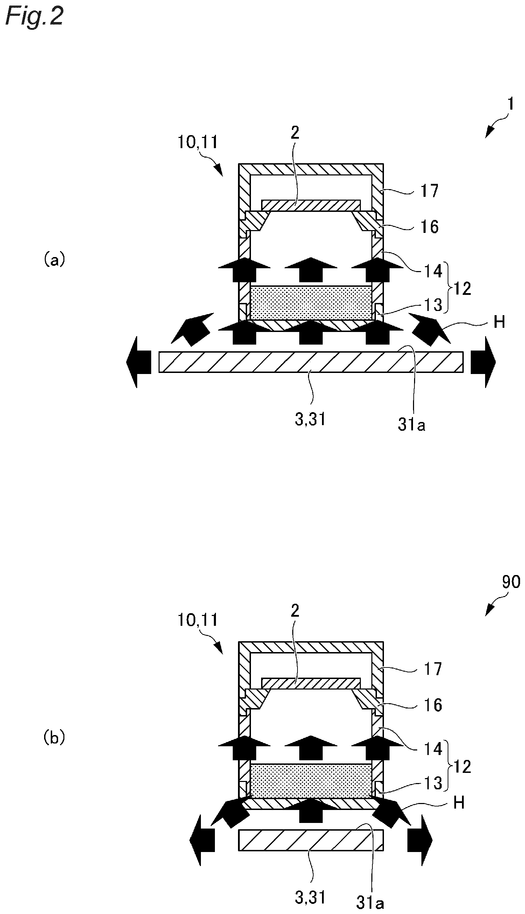

[FIG. 2] FIG. 2 schematically illustrates how heat flows when the heating vessel constituting part of the SiC single-crystal growth apparatus of the first embodiment is heated by the heating member, FIG. 2(a) showing such a case where the relationship B/A≥2 is satisfied, FIG. 2(b) showing a case where the relationship B/A≥2 is not satisfied.

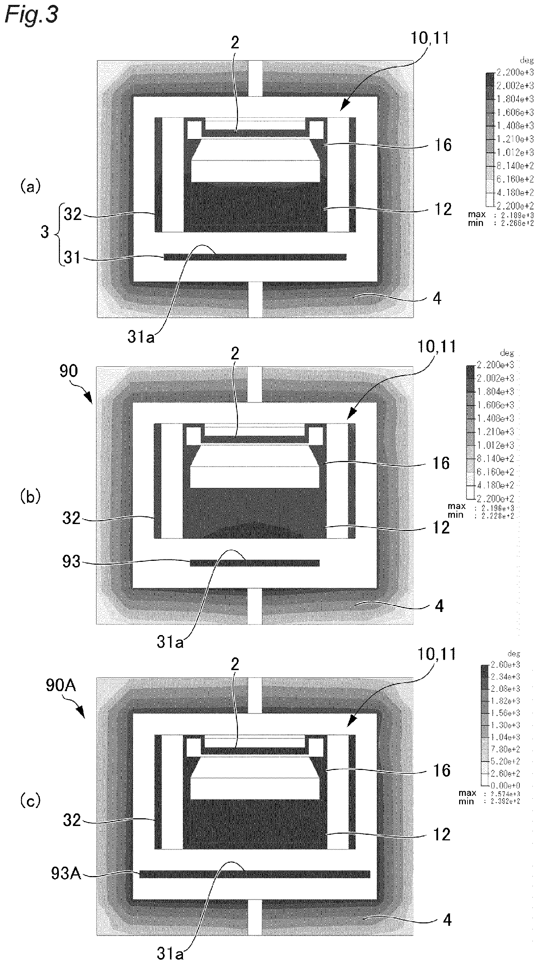

[FIG. 3] FIG. 3 illustrates results of simulations of temperature distribution in SiC single-crystal growth apparatus with different B/A ratios, FIG. 3(a) showing a simulation result where B/A=2, FIG. 3(b) showing a simulation result where B/A=1, FIG. 3(c) showing a simulation results where B/A=3.

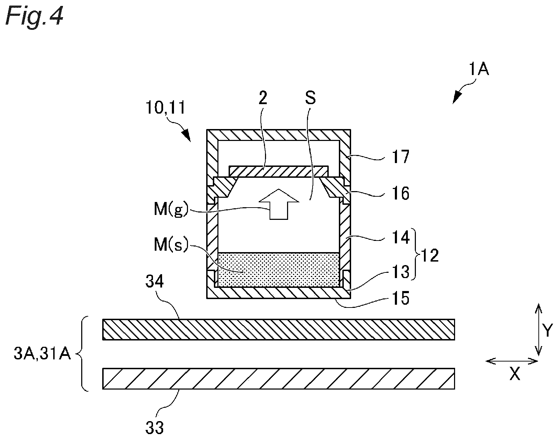

[FIG. 4] FIG. 4 is a cross-sectional view of an SiC single-crystal growth apparatus including a soaking plate for the first heating sub-member, schematically illustrating the structure of its main components.

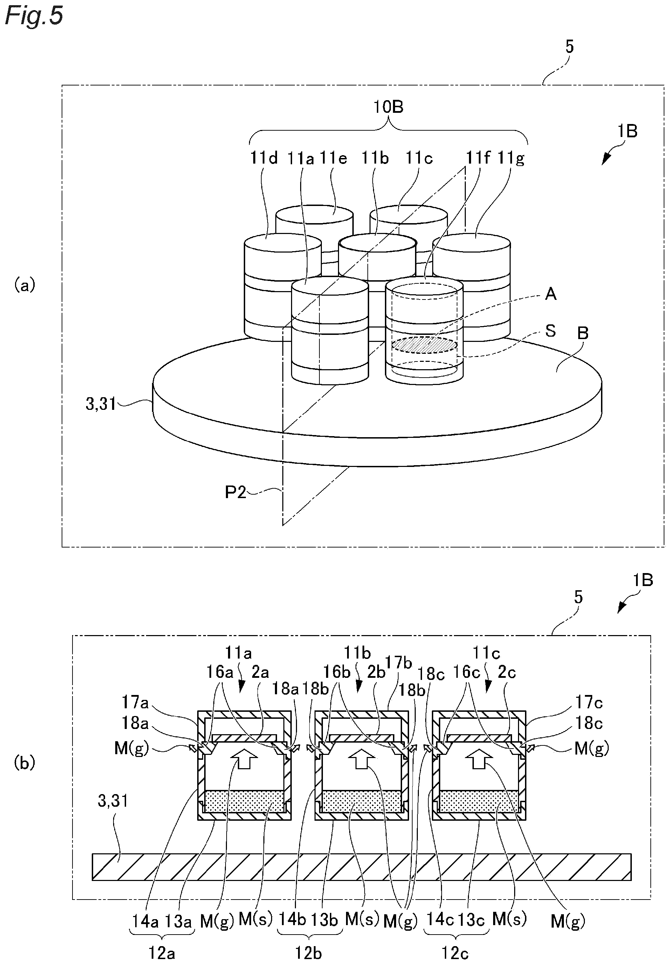

[FIG. 5] FIG. 5 shows an SiC single-crystal growth apparatus of a second embodiment of the present invention, schematically illustrating the structure of its main components, FIG. 5(a) being a perspective view showing one crucible as being transparent so its interior space S is visible, FIG. 5(b) being a cross-sectional view of the apparatus taken on imaginary plane P2 of FIG. 5(a).

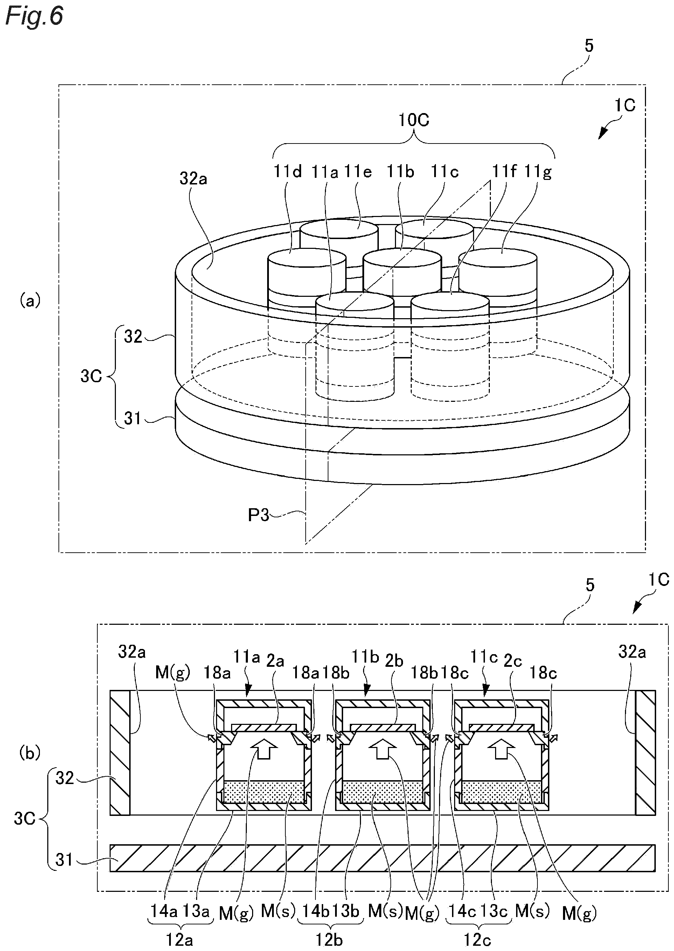

[FIG. 6] FIG. 6 shows an SiC single-crystal growth apparatus of a third embodiment of the present invention, schematically illustrating its structure, FIG. 6(a) being a perspective view, FIG. 6(b) being a cross-sectional view of the apparatus taken on imaginary plane P3 of FIG. 6(a).

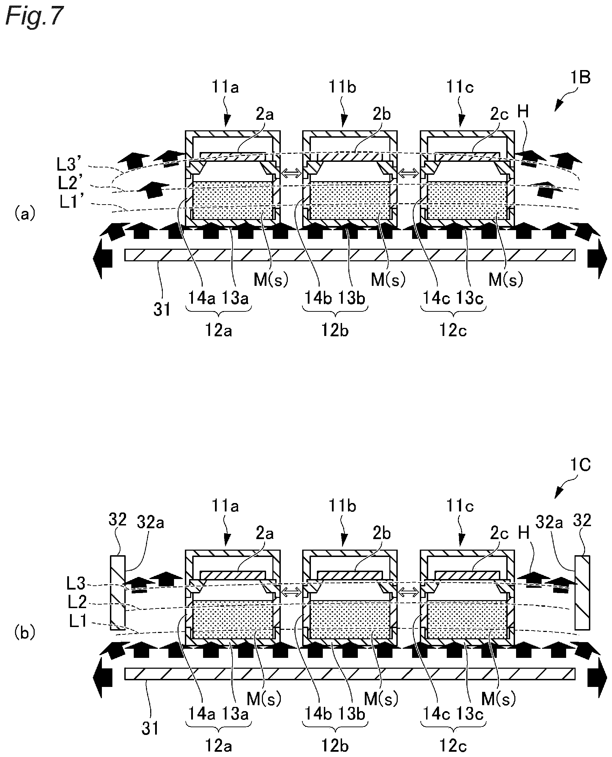

[FIG. 7] FIG. 7 schematically illustrates how heat flows when the heating vessel constituting part of the SiC single-crystal growth apparatus of each of the second and third embodiments is heated by the heating member, FIG. 7(a) showing the SiC single-crystal growth apparatus of the second embodiment, FIG. 7(b) showing the SiC single-crystal growth apparatus of the third embodiment.

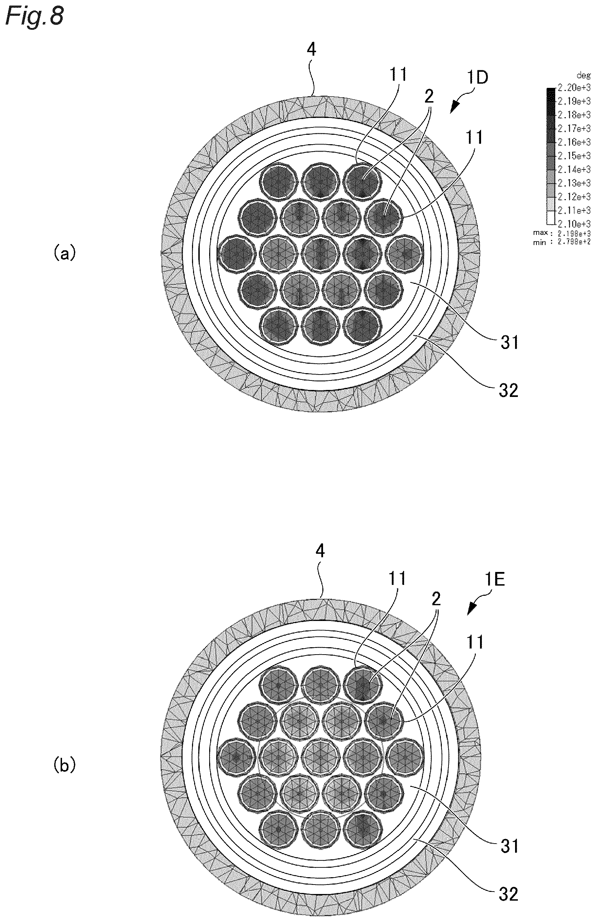

[FIG. 8] FIG. 8 schematically illustrates results of simulations of temperature distribution in SiC seed crystals placed in the heating vessel of the SiC single-crystal growth apparatus with different C/D ratios, FIG. 8(a) showing a simulation result where the relationship C/D≥2 is satisfied, FIG. 8(b) showing a simulation result where the relationship C/D≥2 is not satisfied (i.e., C/D=1).

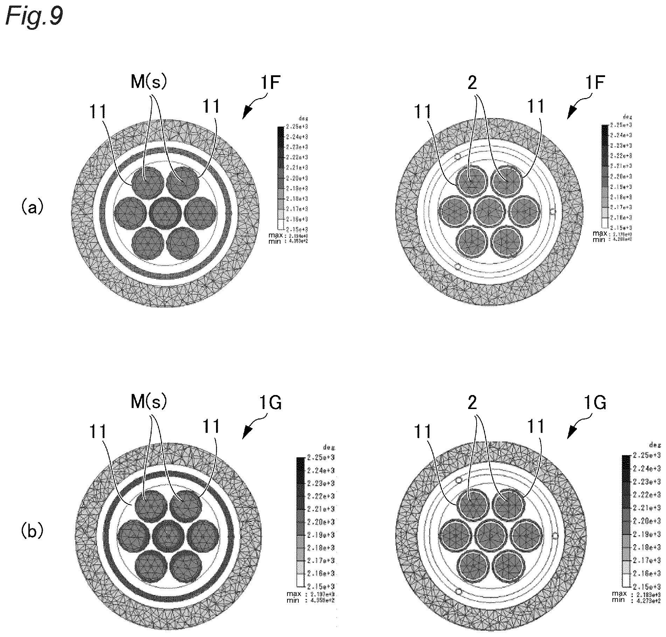

[FIG. 9] FIG. 9 schematically illustrates results of simulations of temperature distribution in the surface of solid source material contained in the heating vessel of the SiC single-crystal growth apparatus and SiC seed crystals placed in the heating vessel with different C/D ratios, FIG. 9(a) showing simulation results where C/D=2.00, FIG. 9(b) showing simulation results where C/D=1.25.

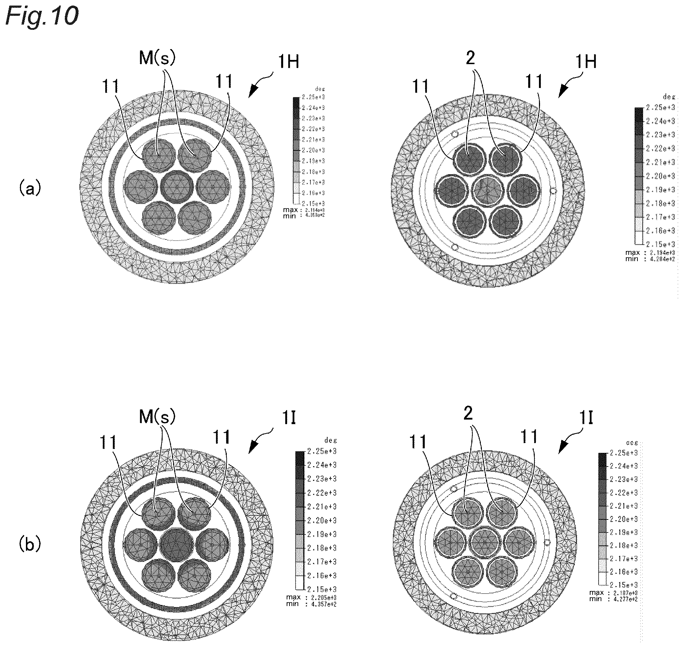

[FIG. 10] FIG. 10 schematically illustrates results of simulations of temperature distribution in the surface of solid source material contained in the heating vessel of the SiC single-crystal growth apparatus and SiC seed crystals placed in the heating vessel with different B/A ratios and different C/D ratios, FIG. 10(a) showing simulation results where B/A=13.3 and C/D=0.50, FIG. 10(b) showing simulation results where B/A=0.30 and C/D=1.25.

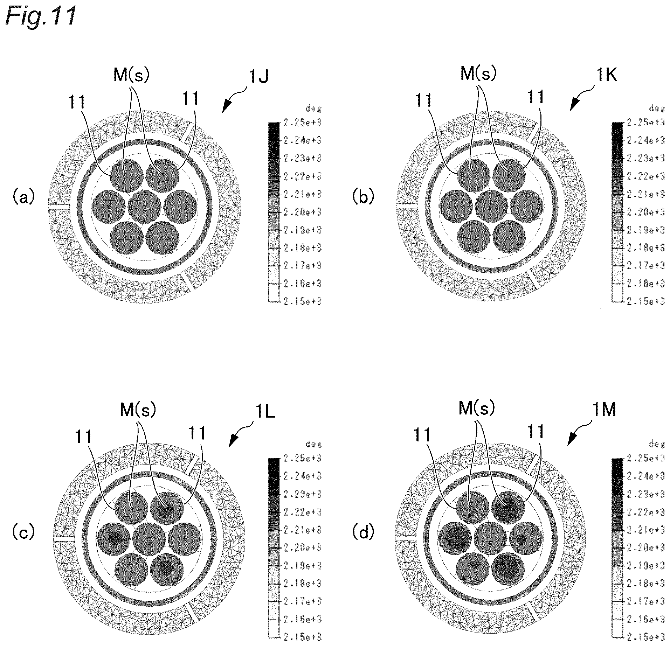

[FIG. 11] FIG. 11 schematically illustrates results of simulations of temperature distribution in the surface of solid source material contained in the heating vessel of the SiC single-crystal growth apparatus with different ratios of the thermal conductivity in a direction along the first heating surface to the thermal conductivity in a direction perpendicular to the first heating surface, FIG. 11(a) showing a simulation result for a ratio of 10, FIG. 11(b) showing a simulation result for a ratio of 4, FIG. 11(c) showing a simulation result for a ratio of 3, FIG. 11(d) showing a simulation result for a ratio of 2.

### EMBODIMENTS FOR CARRYING OUT THE INVENTION

Now, SiC single-crystal growth apparatus of some embodiments of the present invention will be described.

### <First Embodiment>

FIG. 1 shows an SiC single-crystal growth apparatus of a first embodiment the present invention, schematically illustrating the structure of its main components, FIG. 1(a) being a perspective view showing a crucible as being transparent so its interior space S is visible, FIG. 1(b) being a cross-sectional view of the apparatus taken on imaginary plane P1 of FIG. 1(a). FIG. 2 schematically illustrates how heat flows when the heating vessel constituting part of the SiC single-crystal growth apparatus of the first embodiment is heated by the heating member, FIG. 2(a) showing such a case where the relationship B/A≥2 is satisfied, FIG. 2(b) showing a case where B/A≥2 is not satisfied. FIG. 3 illustrates results of simulations of temperature distribution in SiC single-crystal growth apparatus with different B/A ratios, FIG. 3(a) showing a simulation result where B/A=2, FIG. 3(b) showing a simulation result where B/A=1, FIG. 3(c) showing a simulation result where B/A=3.

As shown in FIG. 1, the SiC single-crystal growth apparatus 1 of the first embodiment of the present invention includes: a heating vessel 10 including a material containing portion 12 having a cylindrical peripheral side portion 14 and adapted to contain solid source material M(s) of SiC in a portion of an interior space S defined by the peripheral side portion 14, and a seed-crystal mounting portion 16 located in a portion of the interior space S of the material containing portion 12 that does not contain the solid source material M(s), the seed-crystal mounting portion 16 adapted to allow a seed crystal 2 of SiC to be placed thereon; and a heating member 3 adapted to heat the heating vessel 10, the heating member 3 including at least a first heating sub-member 31 having a first heating surface 31a positioned outside of the heating vessel 10 to face a major surface portion of the material containing portion 12 in such a positional relationship as to cover the entire outer surface of the major surface portion, the major surface portion located opposite to the seed-crystal mounting portion 16, the apparatus satisfying the relationship B/A≥2, where A is the sectional area of the interior space S, and B is the area of the first heating surface 31a.

Thus, if the heating member 3 is implemented as a first heating member 31 positioned in such a positional relationship as to cover the entire outer surface of the major surface portion of the material containing portion 12, such as its bottom surface portion 15, and the area B of the first heating surface 31a of the first heating sub-member 31 is not smaller than twice the sectional area A of the interior space S, then, the entire major surface portion of the material containing portion 12 is heated by the first heating sub-member 31 and, at the same time, the first heating surface 31a of the first heating member 31 is present not only in that region which faces the material containing portion 12, but expands outward of the material containing portion 12, such that heat H is assumed to be less likely to escape from the periphery of the first heating sub-member 31 and nearby locations, outward of the first heating sub-member 31. Thus, the SiC single-crystal growth apparatus 1 is capable of uniformly heating the solid source material M(s) contained inside the material containing portion 12 of the heating vessel 10 (e.g., a plurality of crucibles 11) to sublimate it into solid-source-material-derived gaseous material. Further, if the solid source material M(s) is uniformly heated for sublimation, this increases, during the growth of SiC single crystals, the uniformity of growth rate of SiC single crystals across the various seed crystals and/or the uniformity of growth rate within a single seed crystal, thereby reducing wasted material when substrates or the like are cut out of the resulting SiC single crystals.

The SiC single-crystal growth apparatus 1 of the present embodiment includes at least the heating vessel 10 and the heating member 3.

### (Heating Vessel)

The heating vessel 10 is composed of a single crucible, or a plurality of crucibles, 11. Particularly, in the present embodiment, the heating vessel 10 is composed of a single crucible 11.

The crucible 11 constituting the heating vessel 10 includes a material containing portion 12 having a cylindrical peripheral side portion 14 and adapted to contain solid source material M(s) of SiC in a portion of the interior space S defined by the peripheral side portion 14. The material containing portion 12 includes, for example, a bottom portion 13 and the cylindrical peripheral side portion 14 coupled to the bottom portion 13.

The solid source material M(s) contained in the material containing portion 12 is preferably contained in a portion, as determined along the height direction Y, of the interior space S of the crucible 11 defined by the peripheral side portion 14. Further, the solid source material M(s) is preferably contained by the major surface portion of the crucible 11, which is positioned to face the first heating surface 31a of the first heating member 31, discussed further below. For example, in implementations where the crucible 11 is located above the first heating sub-member 31, as shown in FIG. 1, the major surface portion of the crucible 11 is the bottom surface portion 15 of the bottom portion 13 of the crucible 11. In other implementations where the crucible 11 is located below the first heating sub-member 31, the major surface portion is the upper surface portion of a lid of the crucible 11, and the solid source material M(s) is contained by the surface portion of the crucible opposite to the upper surface portion (not shown).

Further, the crucible 11 constituting the heating vessel 10 includes a seed-crystal mounting portion 16 located in a portion of the interior space S of the material containing portion 12 that does not contain the solid source material M(s), the seed-crystal mounting portion adapted to allow the seed crystal 2 of SiC to be placed thereon. Thus, the solid source material M(s) and seed crystal 2 are located in the same space, i.e., interior space S, such that, when the heating vessel 10 is heated by the heating member 3 discussed below, the solid source material M(s) contained in the material containing portion 12 sublimates into gaseous source material M(g) that can reach the seed crystal 2, thereby growing the SiC single crystal.

The seed crystal 2 of SiC mounted by means of the seed-crystal mounting portion 16 is not limited to any particular size. The SiC single-crystal growth apparatus 1 of the present embodiment is capable of uniformly sublimating the solid source material M(s) located opposite to the seed crystal 2 even if a larger SiC single crystal is to be grown from a seed crystal 2 with a larger growth surface area, such as a crystal with a diameter exceeding 2 inches (50.8 mm) or even a crystal with a diameter not smaller than 6 inches (152.4 mm), thereby enabling efficient growth of SiC single crystals.

Mounting of the seed crystal 2 on the crucible 11 using the seed-crystal mounting portion 16 is not limited to any particular means; for example, to ensure that the lower surface of the seed crystal 2 faces the solid source material M(s), the seed-crystal mounting portion 16 may be constructed by providing a seat protruding from the inner side of the crucible 11 to hold the periphery of the seed crystal 2.

Further, the crucible constituting the heating vessel 10 preferably includes a lid 17 to increase vapor pressure, inside the crucible 11, of gaseous source material M(g) produced through sublimation of the solid source material M(s).

The crucible 11 is preferably formed from a material that can resist high temperatures because it experiences high temperatures when the solid source material M(s) is sublimated to grow the SiC single crystal. Examples of such high-temperature-resistant materials include graphite, tantalum-coated graphite, and tantalum carbide.

### (Heating Member)

The heating member 3 is positioned outside of the heating vessel 10 to heat the heating vessel 10. As the heating member 3 is provided to heat the heating vessel 10, the solid source material M(s) contained in the heating vessel 10 can be heated to sublimate the solid source material M(s). The gaseous source material M(g) produced through sublimation reaches the seed crystal 2 through the interior space S defined by the peripheral side portion 14 of the crucible 11 and is cooled by the seed crystal 2 to grow the SiC single crystal.

The SiC single-crystal growth apparatus 1 of the present embodiment includes at least a first heating sub-member 31 that constitutes the heating member 3. The first heating sub-member 31 includes a first heating surface 31a that positioned to face a portion of the heating vessel 10 located opposite to the seed-crystal mounting portion 16, namely the major surface portion of the material containing portion 12, in such a positional relationship as to cover the entire outer surface of the major surface portion. This allows the entire major surface portion of the material containing portion 12, adjacent to which the first heating sub-member 31 is positioned, to be heated by the first heating sub-member 31.

In implementations where the crucible 11 is located above the first heating sub-member 31, as shown in FIG. 1, the major surface portion of the material containing portion 12 may be the bottom surface portion 15 of the crucible 11. In other implementations where the crucible 11 is located below the first heating sub-member 31, the major surface portion of the material containing portion 12 may be the upper surface portion of the crucible 11 (not shown).

The first heating sub-member 31 constituting the heating member 3 and the crucible 11 constituting the heating vessel 10 are constructed to satisfy the relationship B/A≥2, where A is the sectional area of the interior space S of the crucible 11 and B is the area of the first heating surface 31a.

Thus, as the heating member 3 is implemented as a first heating sub-member 31 positioned relative to the major surface portion of the material containing portion 12, such as the bottom surface portion 15, in such a positional relationship as to cover the entire outer surface of the major surface portion and the area B of the first heating surface 31a of the first heating sub-member 31 is not smaller than twice the sectional area A of the interior space S of the crucible 11, the entire major surface portion of the material containing portion 12 is heated by the first heating sub-member 31 and, at the same time, the first heating surface 31a of the first heating sub-member 31 is not only present in the region that faces the material containing portion 12, but expands outward of the material containing portion 12.

More specifically, as shown in FIG. 2(a), the first heating surface 31a of the first heating sub-member 31, in a cross-sectional view perpendicular to the first heating surface 31a, extends with respect to the major surface portion of the material containing portion 12 (i.e., bottom surface portion 15 in FIG. 2(a)) in at least one direction along the plane of this major surface portion. More preferably, the first heating surface 31a extends with respect to the major surface portion of the material containing portion 12 in two opposite directions along the plane of this major surface portion.

As shown in FIG. 2(a), since the heating member 3 includes a first heating sub-member 31 having a first heating surface 31a extending with respect to the major surface portion of the material containing portion 12, heat H emitted from the first heating surface 31a of the first heating sub-member 31 is uniformly transmitted, by virtue of those portions of the first heating surface 31a which extend with respect to the major surface portion of the material containing portion 12, to the major surface portion of the material containing portion 12 (i.e., bottom surface portion 15 in FIG. 2(a)), and thus uniformly heats the solid source material M(s) contained inside the material containing portion 12. One reason why the major surface portion of the material containing portion 12 can be uniformly heated is that heat H is unlikely to escape from the periphery of the first heating sub-member 31 and nearby locations, outward of the first heating sub-member 31. By comparison, in a case where the relationship B/A≥2 is not satisfied, and particularly in a comparative SiC single-crystal growth apparatus 90 as shown in FIG. 2(b) in which the first heating surface 31a does not extend with respect to the major surface portion of the material containing portion 12, heat H escapes from the periphery of the first heating unit 31 and nearby locations, outward of the first heating unit 31, which is presumably why the major surface portion of the material containing portion 12 cannot easily be heated uniformly.

Thus, to sublimate the solid source material M(s) uniformly, the ratio of the area B of the first heating surface 31a of the first heating sub-member 31 to the sectional area A of the interior space S is to be not lower than 2. On the other hand, to minimize wasted heat, for example, although not limiting, an upper limit for the ratio of the area B of the first heating surface 31a of the first heating sub-member 31 to the sectional area A of the interior space S may be not higher than 3.

FIG. 3 illustrates results of simulations of temperature distribution in SiC single-crystal growth apparatus with different ratios of the area B of the first heating surface 31a of the first heating sub-member 31 to the sectional area A of the interior space S (B/A ratios) when heated with an energy density of 40 W/cm² for all cases, using FEMTET (product name) from Murata Software Co., Ltd. If the ratio of the area B of the first heating surface 31a of the first heating sub-member 31 to the sectional area A of the interior space S is 2, as shown in FIG. 3(a), the solid source material M(s) contained in the material containing portion 12 of the crucible 11 is painted all over with a single thickness indicating a temperature range from not lower than 2002 °C up to 2200 °C, suggesting that the solid source material M(s) is uniformly heated. At this time, the temperature differences in the surface temperature of the solid source material M(s) are preferably not larger than 20°C, and more preferably not larger than 10 °C. On the other hand, if the ratio of the area B of the first heating surface 31a of the first heating sub-member 31 to the sectional area A of the interior space S is smaller than 2, e.g., the ratio of B to A is 1, as shown in FIG. 3(b), the temperatures in some regions of the solid source material M(s) contained in the material containing portion 12 of the crucible 11 are below 2002 °C, suggesting lower uniformity during heating of the solid source material M(s). If the ratio of the area B of the first heating surface 31a of the first heating sub-member 31 to the sectional area A of the interior space S is larger, as shown in FIG. 3(c), the solid source material M(s) contained in the material containing portion 12 of the crucible 11 is also assumed to be heated uniformly; however, since the solid source material M(s) is heated to 2340 °C or higher, there may be some waste of heat.

The heat source 33 of the first heating sub-member 31 constituting the heating member 3 is not limited to any particular type, and may use any known means such as resistance heating or induction heating. Among them, from the viewpoint of easiness of control of the amount of heat emitted from the heat source 33, the heat source is preferably constituted by a resistance heating device, and more preferably constituted by a resistance heating device with a power-feed mechanism with three-phase alternating current (3-phase AC). Further, to improve thermal balance in the first heating sub-member 31, the heat source 33 of the first heating sub-member 31 is preferably located on the side of the first heating sub-member 31 opposite to the first heating surface 31a. Furthermore, the first heating surface 31a of the first heating sub-member 31 may be, as in the SiC single-crystal growth apparatus 1 shown in FIG. 1, a surface of the heat source 33 constituting the first heating sub-member 31, or, as in the SiC single-crystal growth apparatus 1A shown in FIG. 4, a surface of a soaking plate 34 that is a plate-shaped member positioned substantially parallel to the bottom surface of the heating vessel 10 between the heat source 33 and the bottom surface of the heating vessel 10 and constituting part of the first heating sub-member 31 together with the heat source 33.

In the heating member 3, 3A, the first heating surface 31a of the first heating sub-member 31, 31A is preferably produced by an anisotropic material that is anisotropic at least in thermal conductivity. In the heat source 33 and soaking plate 34 having the first heating surface 31a, the thermal conductivity in a direction along the first heating surface 31a is preferably higher than the thermal conductivity in the direction perpendicular to the first heating surface 31a. This slows heat conduction in the thickness direction of the heat source 33 and soaking plate 34 and promotes heat conduction along the first heating surface 31a. This allows heat to be evenly conducted across the entire first heat surface 31a, which allows heat to be uniformly emitted from the first heating surface 31a to the crucible 11. This achieves more uniform heating of the solid source material M(s).

Particularly, if resistance heating or induction heating is used for the heat source, the shape of the heat source itself, the presence of an electrode that supplies the heat source with electricity, and/or the presence of a support member that supports the heat source, for example, may result in non-uniform heat emission across the first heating surface 31a. Even in such cases, if the first heating surface 31a is provided by an anisotropic material that is anisotropic in thermal conductivity, as discussed above, heat can be uniformly emitted from the first heating surface 31a toward the crucible 11.

The anisotropic material used is preferably a carbon material containing carbon fiber. The carbon material containing carbon fiber may be a C/C composite (carbon fiber-reinforced carbon composite). This provides anisotropy to the thermal conductivity of the first heating surface 31a by virtue of the orientation of the carbon fiber and, at the same time, improve mechanical strengths of the anisotropic material, such as tensile strength and/or bending strength. Furthermore, the improved mechanical strengths make it possible to reduce the thicknesses of the heat source 33 and/or soaking plate 34 composed of an anisotropic material, thereby enabling reducing the heat capacity of the heat source 33 and/or soaking plate 34 to allow them to be quickly heated while appropriately supporting the crucible 11 and other components, thereby reducing the energy required to grow the SiC single crystal.

In the anisotropic material, the ratio of the thermal conductivity in a direction along the first heating surface 31a to the thermal conductivity in the direction perpendicular to the first heating surface 31a is preferably not lower than 2, and more preferably not lower than 4. On the other hand, although not limiting, an upper limit for the ratio of the thermal conductivity in a direction along the first heating surface 31a to the thermal conductivity in the direction perpendicular to the first heating surface 31a may be 10 from the viewpoint of heat conduction from the heat source to the crucible 11.

Such an anisotropic material may be disposed, during formation of a material capable of resisting high temperatures such as graphite, by positioning carbon fiber along the surface that is to provide the first heating surface 31a. At this time, the carbon fiber may be disposed by positioning a thin piece of carbon felt or carbon paper along the surface that is to provide the first heating surface 31a.

To increase the mechanical strength of the first heating sub-member 31, 31A to facilitate placing the first heating sub-member 31, 31A into the SiC single-crystal growth apparatus 1, 1A and removing it from the apparatus, the thickness of the anisotropic material is preferably not smaller than 3 mm. On the other hand, to prevent heat from the heat source from being blocked, the thickness of the anisotropic material is preferably not larger than 30 mm.

### <Second Embodiment>

FIG. 5 shows an SiC single-crystal growth apparatus of a second embodiment of the present invention, schematically illustrating the structure of its main components, FIG. 5(a) being a perspective view showing one crucible as being transparent so its interior space S is visible, FIG. 5(b) being a cross-sectional view of the apparatus taken on imaginary plane P2 of FIG. 5(a). In the following description, the same elements as for the first embodiment above are labeled with the same reference numerals and their description will be omitted or simplified, and mainly the differences will be described.

The first embodiment above, as shown in FIGS. 1(a) and 1(b), illustrates an arrangement where the heating vessel 10 includes a single crucible 11; however, the present invention is not limited to such an arrangement. For example, as in the SiC single-crystal growth apparatus 1B shown in FIG. 5(a), the heating vessel 10B may be constituted by a plurality of crucibles 11a to 11g. This allows a plurality of SiC single crystals to be grown simultaneously with a single SiC single-crystal growth apparatus 1B, and dividing a vessel into individual crucibles reduces the weight of a crucible compared with an implementation with one large crucible, thereby facilitating handling. Further, if the heating vessel 10B is constituted by a plurality of crucibles 11a to 11g, this further promotes uniform sublimation of the solid source material M(s).

In the heating member 3, the first heating sub-member 31 is preferably positioned in such a positional relationship as to cover all of the entire surfaces of the major surface portions of the material containing portions 12 of the crucibles 11a to 11g constituting the heating vessel 10B. Further, the first heating sub-member 31 constituting the heating member 3 and the crucibles 11a to 11g constituting the heating vessel 10B are constructed so as to satisfy the relationship B/A≥2, where A is the sectional area of each of the interior spaces S of the crucibles 11a to 11g, and B is the area of the first heating surface 31a. As the heating vessel 10B and the first heating sub-member 31 are thus constructed, even in implementations where a single SiC single-crystal growth apparatus 1B is to grow a plurality of SiC single crystals simultaneously, the solid source material M(s) can be uniformly sublimated as shown in FIG. 5(b) to promote uniform growth of the SiC single crystals from the seed crystals 2a to 2c, thereby increasing productivity of SiC single crystals.

The SiC single-crystal growth apparatus 1B preferably includes the plurality of crucibles 11a to 11g constituting the heating vessel 10B and a chamber 5 containing the heating vessel 10B. This facilitates adjustment of the atmosphere outside the heating vessel 10B, and also makes it less likely that the crucibles 11a to 11g, for example, are damaged by heating.

In such implementations, as shown in FIG. 5(b), the plurality of crucibles 11a to 11c preferably include clearances 18a to 18c that allow some of the solid-source-material-derived gaseous material M(g) produced through sublimation of the solid source material M(s) contained in the respective crucibles 12a to 12c to be released from within the material containing portions to the space within the chamber 5. This allows impurities to be discharged from within the crucibles 11a to 11c through the clearances 18a to 18c. Together with this, the gaseous source material M(g) is released to the space within the chamber 5 through the clearances 18a to 18c of the crucibles 11a to 11c to fill the chamber such that the vapor pressure of the gaseous source material M(g) within the chamber 5 is common to the plurality of crucibles 11a to 11c, which provides a substantially uniform vapor pressure of the gaseous source material M(g) in the plurality of crucibles 11a to 11c (damping effect). This reduces changes over time in the composition of the gaseous source material M(g) due to the impurities within the crucibles 11a to 11c and, at the same time, further promotes uniform growth of the plurality of SiC single crystals.

As shown in FIG. 5(b), the clearances 18a to 18c may be formed by providing gaps between those portions of the crucibles 11a to 11c which engage during assembly. The portions of the crucibles 11a to 11c that engage during assembly may be, for example, the engaging portions of the material containing portions 12a to 12c and of the seed-crystal mounting portions 16a to 16c, or the engaging portions of the seed-crystal mounting portions 16a to 16c and of the lids 17a to 17c.

The number of crucibles included in the SiC single-crystal growth apparatus 1B constituting the heating vessel 10B is not limited to any particular value. For example, to avoid an unnecessarily large empty space between the crucibles, the number is preferably not smaller than 7. On the other hand, the number of crucibles included in the SiC single-crystal growth apparatus 1B may be not larger than 19.

The distance between adjacent ones of the plurality of crucibles 11a to 11g constituting the heating vessel 10B is not limited to any particular value; to improve balance in vapor pressure among the crucibles 11a to 11g, the distance may be not larger than a half of the dimension of each of the crucibles 11a to 11g as measured along the first heating surfaces 31a.

### <Third Embodiment>

FIG. 6 shows an SiC single-crystal growth apparatus of a third embodiment of the present invention, schematically illustrating its structure, FIG. 6(a) being a perspective view, FIG. 6(b) being a cross-sectional view of the apparatus taken on imaginary plane P3 of FIG. 6(a). FIG. 7 schematically illustrates how heat flows when the heating vessel constituting part of the SiC single-crystal growth apparatus of each of the second and third embodiments is heated by the heating member, FIG. 7(a) showing the SiC single-crystal growth apparatus of the second embodiment, FIG. 7(b) showing the SiC single-crystal growth apparatus of the third embodiment. In the following description, the same elements as for the first and second embodiments above are labeled with the same reference numerals and their description will be omitted or simplified, and mainly the differences will be described.

The second embodiment above, as shown in FIGS. 5(a) and 5(b), illustrates an arrangement where the heating member 3 includes a first heating sub-member 31 covering the entire outer surfaces of the major surface portions of the material containing portions 12; however, the present invention is not limited to such an arrangement. For example, as in the SiC single-crystal growth apparatus 1C shown in FIGS. 6(a) and 6(b), the heating member 3C may include, in addition to the first heating sub-member 31, a second heating sub-member 32 having a second heating surface 32a positioned to face the peripheral side portions 14a to 14c of the material containing portions 12a to 12c in such a positional relationship as to entirely cover the outer surfaces of the peripheral side portions 14a to 14c.

In the first and second heating sub-members 31 and 32 constituting the heating member 3C, the heating energy of the first heating sub-member 31, C, is preferably larger than the heating energy of the second heating sub-member 32, D.

As the heating energy C of the first heating sub-member 31 is larger than the heating energy D of the second heating sub-member 32, the solid source material M(s) contained inside the material containing portions of the crucibles 11a to 11g (i.e., material containing portions 12a to 12c of FIG. 6(b)) are uniformly heated; and, at the same time, positioning the crystal growth surfaces of the seed crystals 2a to 2c parallel to the first heating surface 31a achieves a uniform surface temperature of the seed crystals 2a to 2c in the crucibles 11a to 11g, thereby further improving the uniformity of the growth rate of the SiC single crystals.

If the SiC single-crystal growth apparatus 1C includes the second heating sub-member 32 together with the first heating sub-member 31 to provide its heating member 3C and the heating energy C of the first heating sub-member 31 is larger than the heating energy D of the second heating sub-member 32, heat H emitted from the first heating surface 31a of the first heating sub-member 31 is uniformly conveyed in the direction away from the first heating surface 31a (i.e., upward in FIG. 7(b)), as shown in FIG. 7(b), and isotherms L1 to L3 are substantially parallel to the first heating surface 31a, which achieves a uniform surface temperature of the seed crystals 2a to 2c. One reason why such a uniform surface temperature of the seed crystals 2a and 2c can be achieved is that the presence of the second heating sub-member 32 makes it even less likely that heat H escapes from the outer periphery of the first heating sub-member 31 and nearby locations outward of the first heating sub-member 31 and, at the same time, amounts of heat H that have escaped outward of the first heating sub-member 31 and thus have been locally lost are made up for by the second heating sub-member 32, resulting in an equal energy density in the interior spaces S in the crucibles 11a to 11c. By comparison, in the SiC single-crystal growth apparatus 1B of the second embodiment with no second heating sub-member 32, as shown in FIG. 7(a), isotherms L1' to L3' approach the first heating surface 31a going toward locations outward of the first heating sub-member 31 such that some heat H escapes from the outer periphery of the first heating sub-member 31 and nearby locations, outward of the first heating sub-member 31, which makes it difficult to achieve a uniform surface temperature of the seed crystals 2a to 2c. Further, if the heating energy D of the second heating sub-member is too large, the isotherms depart from the first heating surface going toward locations outward of the first heating sub-member, which makes it difficult to achieve a uniform surface temperature of the seed crystals 2a to 2c (not shown).

Thus, to achieve a uniform surface temperature of the seed crystals 2a to 2c, the ratio of the heating energy C of the first heating sub member to the heating energy D of the second heating sub-member (C/D ratio) is preferably larger than 1.00, and more preferably not smaller than 1.20. On the other hand, although not limiting, if it is desired to achieve a more uniform heating of the solid source material M(s), for example, an upper limit for the ratio of the heating energy C of the first heating sub-member to the heating energy D of the second heating sub-member (C/D ratio) may be lower than 3.50, or may be not higher than 3.00.

Although embodiments of the present invention have been described, the present invention is not limited to the above-described embodiments but encompasses any implementations encompassed by the concept of the present invention and the scope of the claims, and may be modified in various manners within the scope of the present invention.

### EXAMPLES

Next, examples of the present invention will be described to further clarify the effects of the present invention, although the present invention is not limited to these examples.

### [Inventive Example 1]

To model crucibles 11 containing solid source material M(s) and seed crystals 2, models of crucibles 11 were constructed that each included a material containing portion 12 with an interior space S having the shape of a circular column with a diameter of 180 mm and a height of 60 mm, the interior space S defined by a cylindrical peripheral side portion 14 with an inner diameter of 180 mm, containing SiC powder constituting the solid source material M(s) (from Pacific Rundum Co., Ltd., type GMF-H) to a height of 70 mm from the bottom of the interior space S, and further provided with a seed-crystal mounting portion 16 located at a height of 60 mm from the bottom of the interior space S, on which a seed crystal 2 with a diameter of 150 mm was placed.

19 such models of crucibles 11 were placed on a first heating sub-member 31 having the shape of a flat plate and including a first heating surface 31 with a diameter of 1100 mm, disposed at equal distances as depicted in FIG. 8(a). Here, the sectional area A of the interior space S of each crucible 11 was calculated as 2.54×10⁴ mm², the area B of the first heating surface 31a as 9.50×10⁵ mm², giving a B/A ratio of 37.4.

The first heating sub-member 31 was constructed by providing a plate-shaped soaking plate 34 positioned substantially parallel to the bottom surfaces of the crucibles 11 and having such a first heating surface 31a as described above, and a heat source 33 positioned adjacent to the surface of the soaking plate 34 opposite to the first heating surface 31a, and constituted by a resistance heating device with a 3-phase AC power-feed mechanism. The soaking plate 34 was made of a C/C composite, i.e., an anisotropic material in which the thermal conductivity in the direction perpendicular to the first heating surface 31a was 10 W/mK and the thermal conductivity in a direction along the first heating surface 31a was 40 W/mK. As such, the ratio of the thermal conductivity in a direction along the first heating surface 31a to the thermal conductivity in the direction perpendicular to the first heating surface 31a was 4.

Further, an apparatus model was constructed to simulate the surface temperature of the solid source material M(s) in an SiC single-crystal growth apparatus, where a cylindrical second heating sub-member 32 with an inner diameter of 1200 mm and a height of 230 mm was positioned outward of the first heating sub-member 31 to be concentric with the first heating sub-member 31 in plan view. Then, the surface temperature of the solid source material M(s) was simulated using FEMTET (product name) from Murata Software Co., Ltd., where the heating energy C of the first heating sub-member was 80 kW, the heating energy D of the second heating sub-member was 40 kW and heating was performed for 300 minutes. In this simulation, the ratio of the heating energy C of the first heating sub-member to the heating energy D of the second heating sub-member (C/D ratio) was 2.00.

As a result of the simulation, it was found that the temperature differences in the surface temperature of the solid source material M(s) were not larger than 10°C. Further, it was found that the temperature differences in the surface temperature of the SiC seed crystal 2 were not larger than 10 °C, as indicated in FIG. 8(a) showing the result of the simulation of temperature distribution in the SiC seed crystals positioned in the crucibles 11 of the SiC single-crystal growth apparatus 1D.

### [Inventive Example 2]

The same apparatus model as for Inventive Example 1 was used to simulate the surface temperature of the solid source material M(s), where the heating energy C of the first heating sub-member was 60 kW, the heating energy D of the second heating sub-member was 60 kW, and heating was performed for 300 minutes. In this simulation, the ratio of the heating energy C of the first heating sub-member to the heating energy D of the second heating sub-member (C/D ratio) was 1.00.

As a result of the simulation, it was found that the temperature differences in the surface temperature of the solid source material M(s) were not larger than 10°C. On the other hand, there were temperature differences in the surface temperature of the SiC seed crystals 2 in the range from above 30 °C up to 40 °C, as indicated in FIG. 8(b) showing the result of the simulation of temperature distribution in the SiC seed crystals positioned in the crucibles 11 of the SiC single-crystal growth apparatus 1E, including the surfaces of the solid source material M(s).

### [Inventive Example 3]

7 such models of crucibles 11 as specified in connection with Inventive Example 1 were placed on a first heating sub-member 31 having the shape of a flat plate and including a first heating surface 31a with a diameter of 650 mm, disposed at equal distances as depicted in FIG. 9(a). In these simulations, the sectional area A of the interior space S of each crucible 11 was calculated as 2.54×10⁴ mm², and the area B of the first heating surface 31a as 3.31×10⁵ mm², giving a B/A ratio of 13.0.

As is the case with Inventive Example 1, the first heating sub-member 31 was constructed by disposing a soaking plate 34 and a heat source 33. The soaking plate 34 was made of a C/C composite, i.e., an anisotropic material in which the thermal conductivity in the direction perpendicular to the first heating surface 31a was 10 W/mK and the thermal conductivity in a direction along the first heating surface 31a was 40 W/mK. As such, the ratio of the thermal conductivity in a direction along the first heating surface 31a to the thermal conductivity in the direction perpendicular to the first heating surface 31a was 4.

Further, an apparatus model was constructed to simulate the surface temperature of the solid source material M(s) in an SiC single-crystal growth apparatus, where a cylindrical second heating sub-member 32 with an inner diameter of 750 mm and a height of 230 mm was positioned outward of the first heating sub-member 31 to be concentric with the first heating sub-member 31 in plan view. Then, the surface temperature of the solid source material M(s) was simulated using FEMTET (product name) from Murata Software Co., Ltd., where the heating energy C of the first heating sub-member was 40 kW, the heating energy D of the second heating sub-member was 20 kW and heating was performed for 300 minutes. In these simulations, the ratio of the heating energy C of the first heating sub-member to the heating energy D of the second heating sub-member (C/D ratio) was 2.00.

FIG. 9(a) shows the result of the simulation of temperature distribution in the surfaces of the solid source material M(s) contained in the crucibles 11 of the SiC single-crystal growth apparatus 1F (on the left) and the result of the simulation of temperature distribution in the SiC seed crystals 2 positioned in the crucibles 11 (on the right). As a result of the simulations, it was found that neither the temperature differences in the surface temperature of the solid source material M(s) nor the temperature differences in the surface temperature of the seed crystals 2 were not larger than 10 °C.

### [Inventive Example 4]

The same apparatus model as for Inventive Example 3 was used to simulate the surface temperature of the solid source material M(s), where the heating energy C of the first heating sub-member was 25 kW, the heating energy D of the second heating sub-member was 20 kW, and heating was performed for 300 minutes. In these simulations, the ratio of the heating energy C of the first heating sub-member to the heating energy D of the second heating sub-member (C/D) ratio was 1.25.

FIG. 9(b) shows the result of the simulation of temperature distribution in the surfaces of the solid source material M(s) contained in the crucibles 11 of the SiC single-crystal growth apparatus 1G (on the left) and the result of the simulation of temperature distribution in the SiC seed crystals 2 positioned in the crucibles 11 (on the right). As a result of the simulations, it was found that neither the temperature differences in the surface temperature of the solid source material M(s) nor the temperature differences in the surface temperature of the seed crystals 2 were not larger than 10 °C.

### [Inventive Example 5]

The same apparatus model as for Inventive Example 3 was used to simulate the surface temperature of the solid source material M(s), where the heating energy C of the first heating sub-member was 20 kW, the heating energy D of the second heating sub-member was 40 kW, and heating was performed for 300 minutes. In these simulations, the ratio of the heating energy C of the first heating sub-member to the heating energy D of the second heating sub-member (C/D ratio) was 0.50.

FIG. 10(a) shows the result of the simulation of temperature distribution in the surface of the solid source material M(s) contained in the crucibles 11 of the SiC single-crystal growth apparatus 1H (on the left) and the result of the simulation of temperature distribution in the SiC seed crystals 2 positioned in the crucibles 11 (on the right). As a result of the simulations, it was found that the temperature differences in the surface temperature of the solid source material M(s) were not larger than 10 °C. On the other hand, there were temperature differences in the surface temperature of the SiC seed crystals 2 in the range from above 20 °C and up to 30 °C.

### [Comparative Example 1]

7 such models of crucibles 11 as specified in connection with Inventive Example 1 were placed on a first heating sub-member 31 having the shape of a flat plate and including a first heating surface 31a with a diameter of 98.6 mm, disposed at equal distances as depicted in FIG. 10(b). The sectional area A of the interior space S of each crucible 11 was calculated as 2.54×10⁴ mm², and the area B of the first heating surface 31a as 7.63×10³ mm², giving a B/A ratio of 0.30.

Further, an apparatus model was constructed to simulate the surface temperature of the solid source material M(s) in an SiC single-crystal growth apparatus, where a cylindrical second heating sub-member 32 with an inner diameter of 750 mm and a height of 230 mm was positioned outward of the first heating sub-member 31 to be concentric with the first heating sub-member 31 in plan view. Then, the surface temperature of the solid source material M(s) was simulated using FEMTET (product name) from Murata Software Co., Ltd., where the heating energy C of the first heating sub-member was 25 kW, the heating energy D of the second heating sub-member was 20 kW and heating was performed for 300 minutes. In these simulations, the ratio of the heating energy C of the first heating sub-member to the heating energy D of the second heating sub-member (C/D ratio) was 1.25.

FIG. 10(b) shows the result of the simulation of temperature distribution in the surface of the solid source material M(s) contained in the crucibles 11 of the SiC single-crystal growth apparatus 1I (on the left) and the result of the simulation of temperature distribution in the SiC seed crystals 2 positioned in the crucibles 11 (on the right). As a result of the simulations, there were temperature differences in the surface temperature of the solid source material M(s) in the range from above 20 °C and up to 30 °C. The temperature differences in the surface temperature of the seed crystal 2 were not larger than 10 °C.

### [Inventive Example 6]

7 such models of crucibles 11 as specified in connection with Inventive Example 1 were placed on a first heating sub-member 31 having the shape of a flat plate and including a first heating surface 31a with a diameter of 650 mm, disposed at equal distances as depicted in FIG. 11(a). In this simulation, the sectional area A of the interior space S of each crucible 11 was calculated as 2.54×10⁴ mm², and the area B of the first heating surface 31a as 3.31×10⁵ mm², giving a B/A ratio of 13.0.

As is the case with Inventive Example 1, the first heating sub-member 31 was constructed by disposing a soaking plate 34 and a heat source 33. The soaking plate 34 was made of a C/C composite, i.e., an anisotropic material in which the thermal conductivity in the direction perpendicular to the first heating surface 31a was 1 W/mK and the thermal conductivity in a direction along the first heating surface 31a was 10 W/mK. As such, the ratio of the thermal conductivity in a direction along the first heating surface 31a to the thermal conductivity in the direction perpendicular to the first heating surface 31a was 10.

Further, an apparatus model was constructed to simulate the surface temperature of the solid source material M(s) in an SiC single-crystal growth apparatus, where a cylindrical second heating sub-member 32 with an inner diameter of 750 mm and a height of 230 mm was positioned outward of the first heating sub-member 31 to be concentric with the first heating sub-member 31 in plan view. Then, the surface temperature of the solid source material M(s) was simulated using FEMTET (product name) from Murata Software Co., Ltd., where the heating energy C of the first heating member was 25 kW, the heating energy D of the second heating member was 20 kW and heating was performed for 300 minutes. In this simulation, the ratio of the heating energy C of the first heating member to the heating energy D of the second heating member (C/D ratio) was 1.25.

FIG. 11(a) shows the result of the simulation of temperature distribution in the surface of the solid source material M(s) contained in the crucibles 11 of the SiC single-crystal growth apparatus 1J. As a result of the simulation, the temperature differences in the surface temperature of the solid source material M(s) were not larger than 10 °C.

### [Inventive Example 7]

The same apparatus model as for Inventive Example 6 was used to simulate the surface temperature of the solid source material M(s), where the thermal conductivity in the direction perpendicular to the first heating surface 31a of a soaking plate 34 made of a C/C composite, i.e., anisotropic material, was 10 W/mK, and the thermal conductivity in a direction along the first heating surface 31a was 40 W/mK. In this simulation, the ratio of the thermal conductivity in a direction along the first heating surface 31a to the thermal conductivity in the direction perpendicular to the first heating surface 31a was 4.

FIG. 11(b) shows the result of the simulation of temperature distribution in the surface of the solid source material M(s) contained in the crucibles 11 of the SiC single-crystal growth apparatus 1K. As a result of the simulation, the temperature differences in the surface temperature of the solid source material M(s) were not larger than 10 °C.

### [Inventive Example 8]

The same apparatus model as for Inventive Example 6 was used to simulate the surface temperature of the solid source material M(s), where the thermal conductivity in the direction perpendicular to the first heating surface 31a of a soaking plate 34 made of a C/C composite, i.e., anisotropic material, was 13.3 W/mK, and the thermal conductivity in a direction along the first heating surface 31a was 40 W/mK. In this simulation, the ratio of the thermal conductivity in a direction along the first heating surface 31a to the thermal conductivity in the direction perpendicular to the first heating surface 31a was 3.

FIG. 11(c) shows the result of the simulation of temperature distribution in the surface of the solid source material M(s) contained in the crucibles 11 of the SiC single-crystal growth apparatus 1L. As a result of the simulation, the temperature differences in the surface temperature of the solid source material M(s) were not larger than 20 °C.

### [Inventive Example 9]

The same apparatus model as for Inventive Example 6 was used to simulate the surface temperature of the solid source material M(s), where the thermal conductivity in the direction perpendicular to the first heating surface 31a of a soaking plate 34 made of a C/C composite i.e., anisotropic material, was 20 W/mK, and the thermal conductivity in a direction along the first heating surface 31a was 40 W/mK. In this simulation, the ratio of the thermal conductivity in a direction along the first heating surface 31a to the thermal conductivity in the direction perpendicular to the first heating surface 31a was 2.

FIG. 11(d) shows the result of the simulation of temperature distribution in the surface of the solid source material M(s) contained in the crucibles 11 of the SiC single-crystal growth apparatus 1M. As a result of the simulation, the temperature differences in the surface temperature of the solid source material M(s) were not larger than 20 °C.

The above demonstrates that, in every one of the SiC single-crystal growth apparatus of Inventive Examples 1 to 9, the ratio of the area B of the first heating surface to the sectional area A of the interior space (B/A) was not lower than 2 and the temperature differences in the surface temperature of the solid source material M(s) were small, which means substantially uniform heating.

Thus, the SiC single-crystal growth apparatus of Inventive Examples 1 to 9 were capable of uniformly heating solid source material to sublimate it into solid-source-material-derived gaseous material, thereby reducing wasted material during the growth of SiC single crystals.

On the other hand, in the SiC single-crystal growth apparatus of Comparative Example 1, the ratio of the area B of the first heating surface to the sectional area A of the interior space (B/A) was lower than 2. As such, in the SiC single-crystal growth apparatus of Comparative Example 1, variations were observed in the surface temperature of the solid source material M(s).

Further, in each of the SiC single-crystal growth apparatus of Inventive Examples 1, 3 and 4, as shown in FIGS. 8 to 10, the ratio of the heating energy C of the first heating sub-member to the heating energy D of the second heating sub-member (C/D ratio) was above 1.00, which, as it was found, resulted in a substantially uniform surface temperature of the seed crystals 2, unlike in Inventive Examples 2 and 5 which had C/D ratios below 1.00.

Further, in each of the SiC single-crystal growth apparatus of Inventive Examples 1 to 7, as shown in FIGS. 8 to 11, the first heating surface 31a was composed of an anisotropic material in which the ratio of the thermal conductivity in a direction along the first heating surface 31a to the thermal conductivity in the direction perpendicular to the first heating surface 31a was not lower than 4, which, as it was found, further reduced the temperature differences in the surface temperature of the solid source material M(s) compared with Inventive Examples 8 and 9, which had a first heating surface 31a composed of a material in which such a ratio between thermal conductivities was lower than 4.

### REFERENCE SIGNS LIST

1, 1A to 1M SiC single-crystal growth apparatus
10, 10B, 10C heating vessel
11, 11a to 11g crucibles
12, 12a to 12c material containing portion
13 bottom portion of material containing portion
14, 14a to 14c peripheral side portion(s) of material containing portion
15 bottom surface portion of material containing portion
16, 16a to 16c seed-crystal mounting portion(s)
17, 17a to 17c lid(s)
18a to 18c clearances
2, 2a to 2c SiC seed crystal(s)
3 heating member
31 first heating sub-member
31a first heating surface
32 second heating sub-member
32a second heating sub-surface
33 heat source
34 soaking plate
4 insulator
5 chamber
90 comparative SiC single-crystal growth apparatus
A sectional area of interior space
B area of first heating surface
H flow of heat emitted from heating member
L1 to L3, L1' to L3' isotherms
S interior space
Y height direction
M(s) solid source material
M(g) gaseous material

## Claims

1. An SiC single-crystal growth apparatus comprising:
a heating vessel including a material containing portion having a cylindrical peripheral side portion and adapted to contain solid source material of SiC in a portion of an interior space defined by the peripheral side portion, and
a seed-crystal mounting portion located in a portion of the interior space of the material containing portion that does not contain the solid source material, the seed-crystal mounting portion adapted to allow a seed crystal of SiC to be placed thereon; and
a heating member adapted to heat the heating vessel,
the heating member including at least a first heating sub-member having a first heating surface positioned outside of the heating vessel to face a major surface portion of the material containing portion in such a positional relationship as to cover an entire outer surface of the major surface portion, the major surface portion located opposite to the seed-crystal mounting portion,
the apparatus satisfying the relationship B/A≥2, where A is a sectional area of the interior space and B is an area of the first heating surface.

2. The SiC single-crystal growth apparatus according to claim 1, wherein:
the heating member further includes a second heating sub-member having a second heating surface positioned outside of the heating vessel to face the peripheral side portion of the material containing portion in such a positional relationship as to cover an entire outer surface of the peripheral side portion; and
C is larger than D, where C is heating energy of the first heating sub-member and D is heating energy of the second heating sub-member.

3. The SiC single-crystal growth apparatus according to claim 2,
wherein the heating energy C of the first heating sub-member and the heating energy D of the second heating sub-member satisfy the relationship C/D≥1.20.

4. The SiC single-crystal growth apparatus according to claim 1, 2 or 3, wherein the heating vessel includes a plurality of crucibles,
the SiC single-crystal growth apparatus further comprising: a chamber adapted to contain the plurality of crucibles and the heating member,
wherein the plurality of crucibles each include a clearance for releasing, from the associated material containing portion to inside the chamber, a portion of solid-source-material-derived gaseous material produced by sublimating the solid source material contained in the material containing portion.

5. The SiC single-crystal growth apparatus according to any one of claims 1 to 4, wherein the first heating surface of the heating member is formed from an anisotropic material anisotropic in at least thermal conductivity.

6. The SiC single-crystal growth apparatus according to claim 5, wherein the anisotropic material is a carbon material containing carbon fiber.

7. The SiC single-crystal growth apparatus according to any one of claims 1 to 6, wherein:
the heating member includes a heat source for the first heating surface, the heating source located on a side of the first heating sub-member opposite to the first heating surface; and
the heating source is formed by a resistance heating device including a power-feed mechanism with three-phase alternating current.
